# EUROPEAN PATENT APPLICATION

(11) **EP 2 197 105 A1**
(43) Date of publication of application: **16.06.2010**
(21) Application number: 08834326.4
(22) Date of filing: 26.09.2008
(51) Int. Cl.: H03G 3/30, G06F 1/26, H02J 1/00, H04R 3/00, H04S 7/00

(54) **ELECTRONIC DEVICE**

(30) Priority: 27.09.2007 JP 2007251923; 05.10.2007 JP 2007261899
(71) Applicant: Yamaha Corporation, Hamamatsu-shi, Shizuoka 430-8650 (JP)
(72) Inventor: KAJITA, Haruo, Hamamatsu-shi Shizuoka 430-8650 (JP)
(74) Representative: Wagner, Karl H.
(86) International application number: PCT/JP2008/067971
(87) International publication number: WO 2009/041717

(57) **Abstract**

Provided is an electronic device which can prevent operation stop attributed to lowering of an electronic device operation voltage. A pre-stage of a power amplifier (24) is connected to a capacitor and a first and a second current limit circuit. A CPU (21) monitors a voltage of the capacitor and corrects a gain of the power amplifier (24) in accordance with the voltage value. Moreover, when the electronic device includes a speaker system having a plurality of channels, an audio signal reproduction mode is switched, for example, between a stereo reproduction and a monaural reproduction according to the voltage value of the capacitor.

## Description

### Technical Field

The present invention relates to an electronic device operable with low electric power supply and at large instantaneous power consumption.

### Background Art

Conventionally, a bus-powered potable USB device has been known. However, USB bus power has a current supply ability of only 100 mA (about 500 mA at the maximum). Thus, an AC adapter is generally used for power supply to a USB device having a large current consumption.

In this regard, for example, Japanese Laid-open Patent Publication No. 2005-141732 discloses a USB device supplied with electric power from a USB port of a host device via two USB cables (i.e., one USB cable and a DC to USB conversion cable). The DC to USB conversion cable has a USB plug adapted for connection with the USB port of the host device, a DC plug adapted for connection with a DC jack of the USB device, and a detection circuit for detecting that the conversion cable is connected to the host device. When the conversion cable is connected to the host device, electric power is supplied from the host device via the conversion cable to the USB device.

However, the power supply method disclosed in Japanese Laid-open Patent Publication No. 2005-141732 does not conform to the USB standard, and does not guarantee a stable operation. In addition, the shortage of power supply can still occur in an electronic device including an electronic component part such as a power amplifier that requires an instantaneous current of about several amperes. The shortage of power supply causes a decrease in driving voltage of the power amplifier, resulting in a problem that the entire operation of the electronic device suddenly stops.

### Disclosure of Invention

The present invention provides an electronic device capable of preventing operation stop caused by a reduction in driving voltage of the electronic device.

The present invention also provides an electronic device capable of realizing a stable operation while ensuring an amount of electric power supply (especially, an amount of driving current supply) to the electronic device.

An electronic device according to a first aspect of this invention comprises a power input unit configured to be supplied with electric power, a main drive circuit configured to be driven with electric power supplied from the power input unit, and a control unit configured to correct a gain of the main drive circuit in accordance with a voltage value of the main drive circuit.

With this construction, the gain is corrected in accordance with a voltage value of the main drive circuit. More specifically, if the voltage value is small, the gain is set to be small to suppress an amount of power consumption, thereby preventing a sudden operation stop of the main drive circuit.

The electronic device of this invention can include an electricity storage circuit connected to a stage preceding the main drive circuit, and the control unit can control the gain of the main drive circuit in accordance with a voltage value of the electricity storage circuit.

With this construction, electric power is stored in the electricity storage circuit (e.g., a capacitor) connected in a stage preceding the main drive circuit. When the main drive circuit consumes electric power exceeding supplied electric power, electric power is supplied from the electricity storage circuit. At that time, the control unit corrects the gain of the main drive circuit in accordance with a voltage value of the electricity storage circuit. Specifically, when the voltage value decreases, the gain is set to be small to suppress the power consumption, whereby a sudden operation stop of the main drive circuit caused by a voltage reduction can be prevented.

The main drive circuit can be a power amplifier, and the control unit can correct the gain of the power amplifier in accordance with decrease in voltage value of the electricity storage circuit.

With this construction, the gain of the power amplifier is corrected. Specifically, if the voltage of the electricity storage circuit decreases, an emitted sound volume is reduced to suppress the power consumption, whereby a sudden operation stop can be prevented.

An electronic device according to a second aspect of this invention comprises a power input unit configured to be supplied with electric power, a power amplifier configured to be driven with electric power supplied from the power input unit, a plurality of speaker units configured to input an audio signal amplified by the power amplifier and emit sounds, and a control unit configured to change, in accordance with a voltage value of the power amplifier, a way of supply of the audio signal to the power amplifier and the speaker units.

With this construction, the way of audio signal supply is changed in accordance with a voltage value of the power amplifier. For example, if a voltage reduction is large, monaural (one channel) reproduction is performed, whereas if a voltage reduction is small, stereo reproduction is performed.

The electronic device of this invention can include an electricity storage circuit connected to a stage preceding the power amplifier, and the control unit can change, in accordance with a voltage value of the electricity storage circuit, the way of supply of the audio signal to the power amplifier and the speaker units.

With this construction, the way of audio signal supply is changed in accordance with a voltage value of the electricity storage circuit. For example, if a voltage reduction is large, monaural (one channel) reproduction is performed, whereas if a voltage reduction is small, stereo reproduction is performed.

In a case where the voltage value of the electricity storage circuit or the power amplifier is at or near its upper limit, the control unit can perform audio signal processing, including phase control, on the audio signal to be supplied to the plurality of speaker units such that a virtual sound source will be generated in a sound emission space.

With this construction, if the voltage value of the electricity storage circuit or the power amplifier is at or near its upper limit value (e.g., a value corresponding to a fully charged state of a capacitor), the phase control for the audio signal is performed using the speaker units to reproduce the audio signal such that a virtual sound source will be generated.

According to the first and second aspects of this invention, it is possible to prevent operation stop of the electronic device caused by a reduction in operation voltage of the electronic device.

An electronic device according to a third aspect of this invention comprises a plurality of power input units configured to be supplied with electric power of different electric currents, a plurality of current limiting circuits configured to limit, using different limit values, respective ones of currents input from the plurality of power input units and to output resultant currents, a main drive circuit connected to a stage subsequent to the plurality of current limiting circuits, an electricity storage circuit connected between the plurality of current limiting circuits and the main drive circuit, and a control unit configured to switch a form of connection between the plurality of power input units and the plurality of current limiting circuits based on a form of current supply via at least one of the plurality of power input units.

With this construction, the power input units are provided which are supplied with electric power of different electric currents, and the current limiting circuits are provided which have different limit values. At least one of the current limiting circuits limits an electric current input from at least one of the power input units, and outputs the resultant electric current to the main drive circuit (e.g., a power amplifier). Electric power is stored in the electricity storage circuit (e.g., a capacitor) connected between the current limiting circuits and the main drive circuit. Electric power is supplied from the electricity storage circuit when the main drive circuit consumes electric power of an electric current value, which is equal to or larger than a value of current output from the current limiting circuit concerned. At that time, in accordance with the form of supply of electric current via the at least one of the power input units, the form of connection between the power input units and the current limiting circuits is switched. In a case, for example, that electric power is supplied via a power input unit supplied with a large electric current, such power input unit is connected to a current limiting circuit having a large limit value, whereby a large electric current is supplied to the main drive circuit and the electricity storage circuit. On the other hand, in a case that electric power is supplied via a power input unit supplied with a small electric current, such power input unit is connected to a current limiting circuit having a small limit value, whereby a small electric current is supplied to the main drive circuit and the electricity storage circuit. As a result, stable driving can be realized.

The plurality of power input units can be comprised of a power input unit for bus power configured to be supplied with electric power from a host device and a power input unit for self power configured to be supplied with electric power from an AC adapter, the control unit can connect the power input unit for bus power to one having a small limit value among the plurality of current limiting circuits in a case where electric power is supplied from the power input unit for bus power, and the control unit can connect the power input unit for self power to one having a large limit value among the plurality of current limiting circuits in a case where electric power is supplied from the power input unit for self power.

With this construction, the electronic device is driven while making switching between bus power from the host device and self power by the AC adapter. In the case of bus-powered driving, the power input unit for bus power is connected to the current limiting circuit having a small limit value, and a small electric current is supplied to the main drive circuit and the electricity storage circuit. In the case of self-powered driving, the power input unit for self power is connected to the current limiting circuit having a large limit value, and a large electric current is supplied to the main drive circuit and the electricity storage circuit. A further large electric current can be supplied when electric currents are supplied from both the host device and the AC adapter via the power input unit for bus power and the power input unit for self power.

The power input unit for bus power can be comprised of a USB interface, and the control unit can connect the power input unit for bus power to the current limiting circuit having the small limit value in a case where negotiation with the host device is established.

With this construction, the bus-powered driving is performed, if the connection with the host device is established via the USB interface and negotiation between the host device and the control unit is established. If negotiation is unsuccessful, electric power is made OFF.

The electricity storage circuit can be configured by an electric double layer capacitor.

According to the third aspect of this invention, it is possible to realize a stable operation of the electronic device, while ensuring an amount of electric power supply (especially, an amount of electric current supply) to the electronic device.

### Brief Description of Drawings

FIG. 1 is a block diagram showing the construction of a power circuit of a speaker apparatus according to one embodiment of this invention;
FIG. 2 is a view showing contents of operation of the speaker apparatus in respective ones of six operation states of the speaker apparatus;
FIG. 3A is a part of a flowchart showing the procedures of an operation state switching process performed by the speaker apparatus connected to a host device;
FIG. 3B is the remaining part of the flowchart that follows FIG. 3A;
FIG. 4A is a part of a flowchart showing the procedures of an operation state switching process performed by the speaker apparatus connected to an AC adapter;
FIG. 4B is a part of the flowchart that follows FIG. 4A;
FIG. 4C is the remaining part of the flowchart that follows FIG. 4A;
FIG. 5 is a view showing a change in voltage of a capacitor with change in power consumption of a power amplifier;
FIG. 6 is a view showing the concept of gain control for the power amplifier performed in accordance with the voltage of the capacitor; and
FIG. 7 is a block diagram showing an audio signal processing system of the speaker apparatus.

### Best Mode for Carrying Out the Invention

In the following, an electronic device according to one embodiment of this invention will be described. The electronic device of this embodiment is in the form of a portable speaker apparatus adapted to be driven with either or both of bus power via USB connection and self power via AC adapter connection.

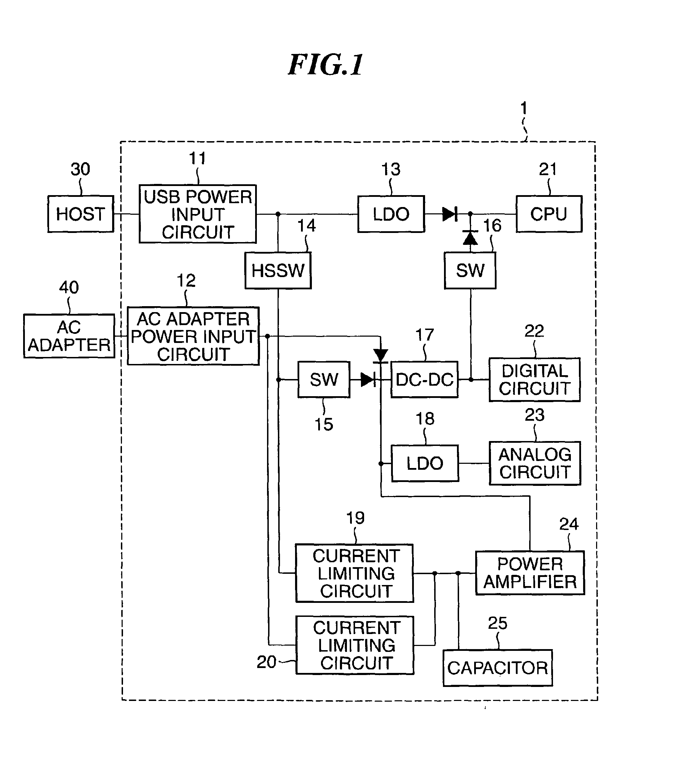

FIG. 1 shows in block diagram the construction of a power circuit of the speaker apparatus of this embodiment. As shown in FIG. 1, the speaker apparatus 1 includes a USB power input circuit 11, an AC adapter power input circuit 12, first and second regulators 13, 18, first to third switches 14 to 16, a DC-DC converter 17, first and second current limiting circuits 19, 20, a CPU 21, a digital circuit 22, an analog circuit 23, a power amplifier 24, and a capacitor 25. Hereinafter, the first and second regulators 13, 18 will be referred to as the first and second LDOs 13, 18, and the first to third switches 14 to 16 will be referred to as the HSSW 14, the second SW 15, and the third SW 16, respectively.

The CPU 21 is a control unit for performing overall control of the speaker apparatus 1. The digital circuit 22 and the analog circuit 23 perform various audio processing. After being processed in the digital circuit 22 and the analog circuit 23, an audio signal is amplified by the power amplifier 24 and emitted as a sound to the outside.

The USB power input circuit 11 is an interface circuit that can be connected to a USB port of a host device 30. The host device 30 is, e.g., an information processing apparatus such as a PC. The USB power input circuit 11 is supplied with electric power of 100 mA or 500 mA from the USB port. The speaker apparatus 1 is driven with bus power when an electric current input from the USB power input circuit 11 is supplied to the CPU 21, the digital circuit 22, and the analog circuit 23. A USB device when connected with the host device 30 is supplied with electric power of 100 mA from the host device 30. Subsequently, if a negotiation with the host device 30 is established, the USB device can be supplied with electric power of 500 mA. If the negotiation cannot be established, the USB device remains supplied with electric power of 100 mA.

The AC adapter power input circuit 12 is an interface circuit that can be connected to the AC adapter 40, and is supplied with electric power of, e.g., about 700 mA from the AC adapter 40. The speaker apparatus 1 is driven with self power when an electric current input from the AC adapter power input circuit 12 is supplied to the CPU 21, the digital circuit 22, and the analog circuit 23.

The first LDO 13 is turned on and off in conjunction with power supply from the power input circuits 11, 12. When supplied with electric power from the USB power input circuit 11, the first LDO 13 is turned on and stabilizes an output voltage of the circuit 11 at 3.3 V. The first LDO 13 is turned off when supplied with electric power from the AC adapter power input circuit 12.

The HSSW 14, which is a switch circuit controlled by the CPU 21, is turned on in the case of the bus-powered driving. Otherwise, the HSSW 14 is turned off.

The second SW 15, which is a switch circuit controlled by the CPU 21, is turned on in the case of the bus-powered driving.

The third SW 16 is turned on when supplied with electric power from the AC adapter power input circuit 12.

The DC-DC converter 17 for voltage transformation transforms a voltage to be supplied to the digital circuit 22 and the CPU 21 from 5 V to 3.3 V.

The second LDO 18 is normally turned on and stabilizes a voltage to be supplied to the analog circuit 23 at 3.3 V.

The first and second current limiting circuits 19, 20 limit an electric current to be supplied to the power amplifier 24 and the capacitor 25. The first current limiting circuit 19 limits its output current to 100 mA, and the second current limiting circuit 20 limits its output current to 150 mA.

The capacitor 25 is an electric double layer capacitor that has an extremely large electrostatic capacity (e.g., not less than several tens of µF). Since the capacitor 25 has an extremely large electrostatic capacity, the CPU 21, etc. become inoperable, if an electric current from the USB power input circuit 11 and/or from the AC adapter power input circuit 12 is all consumed for charging the capacitor 25. To ensure operations of various circuits of the speaker apparatus, the first and second current limiting circuits 19, 20 are provided at a stage preceding the capacitor 25 to limit an electric current supplied to the capacitor.

In this embodiment, electric power is stored in the capacitor 25 so that the stored electric power can be supplied from the capacitor 25 to the power amplifier 24 when the speaker apparatus 1 emits sounds while instantaneously consuming electric power of about several watts. In order to realize stable power supply, the speaker apparatus 1 of this embodiment performs ON/OFF switching of the first LDO 13, the HSSW 14, the second SW 15, and the third SW 16 in accordance with the form of electric power supply from the USB power input circuit 11 and/or the AC adapter power input circuit 12, while storing electric power in the large-capacity capacitor 25. Nevertheless, if sound emission is continued and the power amplifier 24 continuously consumes electric power, a voltage across the capacitor 25 can decrease to or below a drive limit value (e.g., 2.7 V or less). In this embodiment, therefore, various operations are performed to suppress the voltage reduction.

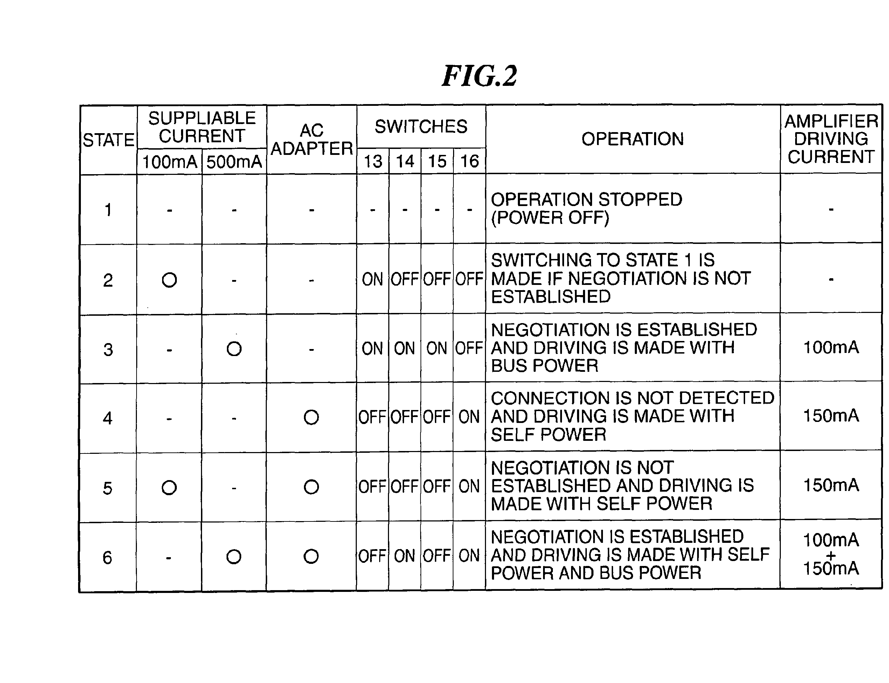

FIG. 2 shows the ON/OFF actions of the first LDO 13 and the first to third SWs 14 to 16 and the action of the CPU 21 in respective ones of six operation states of the speaker apparatus 1. As shown in FIG. 2, the speaker apparatus 1 is switched between its first to sixth operation states in accordance with the form of electric power supply from the power input circuits 11, 12. Specifically, the speaker apparatus 1 is switched to the first operation state, if electric power is supplied neither from the USB power input circuit 11 nor from the AC adapter power input circuit 12, i.e., if neither the host device 30 nor the AC adapter 40 is connected to the speaker apparatus 1. In the first operation state, the CPU 21 is not driven and the switches 13 to 16 remain OFF.

When the speaker apparatus 1 is connected to the host device 30 so that an electric current of 100 mA is input from the USB power input circuit 11 to the speaker apparatus 1, the speaker apparatus 1 is switched to the second operation state. In the second operation state, the first LDO 13 is turned on and electric power is supplied to the CPU 21 via the LDO 13, and as a result, the CPU 21 is activated. The CPU 21 performs negotiation with the host device 30. If the negotiation is not successful, the CPU 21, determining that the speaker apparatus 1 cannot be driven, turns off the power switches 14 to 16, and switches the speaker apparatus 1 to the first operation state.

If the negotiation with the host device 30 is established, the CPU 21, determining that bus-powered driving can be made while inputting an electric current of 500 mA, turns on the HSSW 14 and the second SW 15 to thereby switch the speaker apparatus 1 to the third operation state. In the third operation state, electric power input from the USB power input circuit 11 is supplied to the digital circuit 22, the analog circuit 23, and the first current limiting circuit 19, and electric power of 5V is supplied to the power amplifier 24. Thus, the speaker apparatus 1 is driven with bus power.

At that time, the first current limiting circuit 19 limits its output current to 100 mA and supplies the output current to the power amplifier 24. With this current, the capacitor 25 is charged. When the voltage of the capacitor 25 increases to about 2. 7 V, sufficient electric power (electric current exceeding 100 mA) can be supplied to the power amplifier 24 even in the bus-powered driving. In practice, taking into account of a margin, the voltage may be increased to about 3 V to 3.5 V before being used for the driving.

Specifically, the power amplifier 24 is supplied with an electric current of 100 mA from the first current limiting circuit 19, and amplifies an audio signal. Depending on the degree of amplification, the power amplifier 24 sometimes consumes an electric current exceeding 100 mA. In that case, the capacitor 25 supplies deficient current. If the power amplifier 24 consumes an electric current exceeding 100 mA, the voltage of the capacitor 25 decreases. However, since an electric current of 100 mA is always supplied from the first current limiting circuit 19, the capacitor 25 is again charged when the current consumption by the power amplifier 24 decreases. Even in the bus-powered driving, the speaker apparatus 1 is therefore able to instantaneously output electric power of about several watts, whereby stable driving can be achieved.

When the speaker apparatus 1 is not connected to the host device 30, but the AC adapter 40 is connected to the speaker apparatus 1, an electric current of about 700 mA is input from the AC adapter power input circuit 12, and the speaker apparatus 1 is switched to the fourth operation state. In the fourth operation state, the third SW 16 is turned on and electric power is supplied to the CPU 21. As a result, the CPU 21 is activated. It should be noted that a power line extending from the AC adapter power input circuit 12 to the DC-DC converter 17 is monitored by a detection circuit (not shown), and the third SW 16 is turned on when electric current is supplied to the power line.

After being activated, the CPU 21 turns off the first LDO 13, the HSSW 14, and the second SW 15. As a result, electric power input from the AC adapter power input circuit 12 is supplied to the digital circuit 22, the analog circuit 23, and the second current limiting circuit 20, and electric power of 5V is supplied to the power amplifier 24. Thus, the speaker apparatus 1 is driven with self power.

At that time, the second current limiting circuit 20 limits its output current to 150 mA, and supplies the resultant output current to the power amplifier 24. The capacitor 25 is charged by the output current. As previously described, when the voltage of the capacitor 25 increases to about several volts, sufficient electric power can be supplied to the power amplifier 24.

In the self-powered driving, the power amplifier 24 is supplied with an electric current of 150 mA from the second current limiting circuit 20, and amplifies an audio signal. Depending on the degree of amplification, the power amplifier 24 sometimes consumes an electric current exceeding 150 mA. In that case, the capacitor 25 supplies deficient current. If the power amplifier 24 consumes electric current exceeding 150 mA, the voltage of the capacitor 25 decreases. However, since an electric current of 150 mA is always supplied from the second current limiting circuit 20, the capacitor 25 is again charged when the current consumption by the power amplifier 24 becomes small. Accordingly, the speaker apparatus 1 can be driven more stably than in the case of the bus-powered driving.

When the speaker apparatus 1 is connected to the host device 30 in the self-powered driving state, an electric current of 100 mA is supplied from the USB power input circuit 11, and the speaker apparatus 1 is switched to the fifth operation state. In the fifth operation state, the CPU 21 performs negotiation with the host device 30. If the negotiation is unsuccessful, the speaker apparatus 1 is driven with self power, while maintaining the switches in their ON/OFF states assumed in the fourth operation state.

If the negotiation with the host device 30 is established, the speaker apparatus 1 is switched to the sixth operation state. In the sixth operation state, the CPU 21 turns on the HSSW 14, and supplies the first current limiting circuit 19 with an electric current input from the USB power input circuit 11. As a result, an electric current of 100 mA is supplied from the first current limiting circuit 19 to the power amplifier 24, and an electric current of 150 mA is supplied from the second current limiting circuit 20 to the power amplifier 24. Accordingly, an electric current of 250 mA is supplied to the power amplifier 24 and the capacitor 25. In other words, the speaker apparatus 1 is driven with both bus power and self power.

If the AC adapter 40 is connected to the speaker apparatus 1 in the bus-powered driving state (third operation state), the CPU 21 turns on the third SW 16 and turns off the first LDO 13 and the second SW 15, so that the speaker apparatus 1 is switched to the sixth operation state.

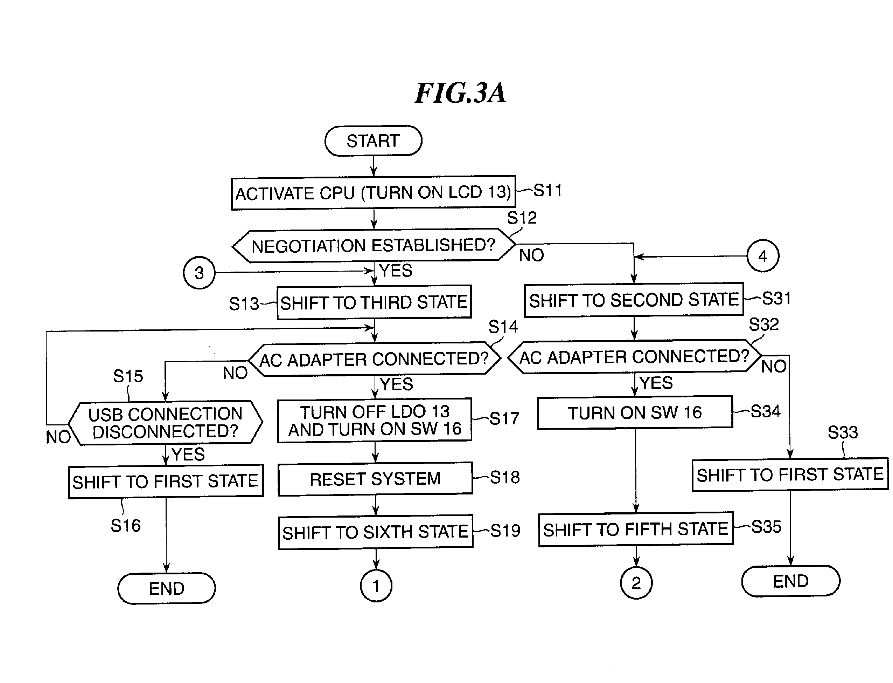

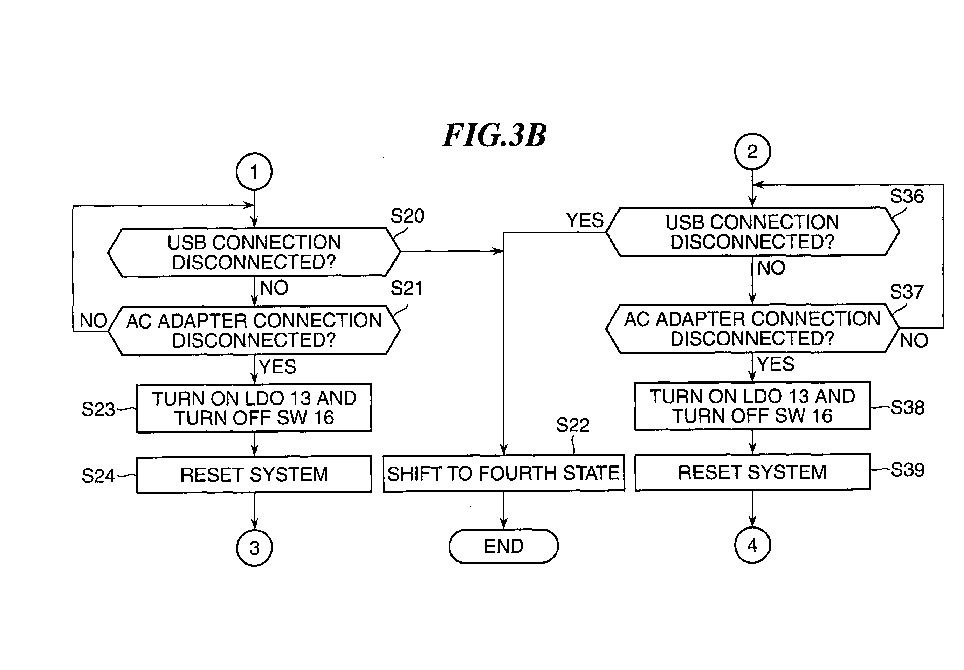

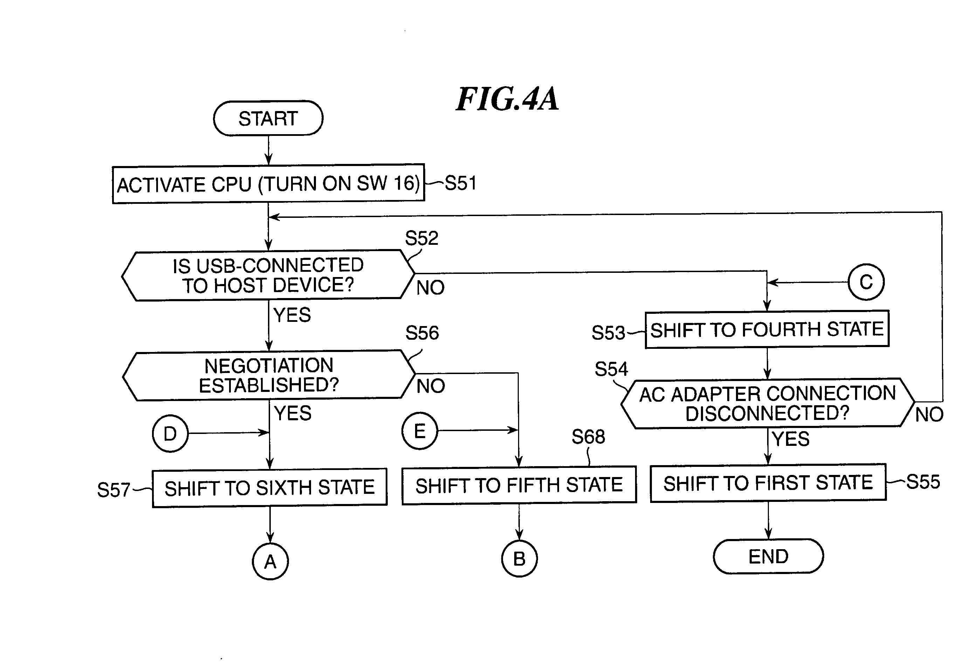

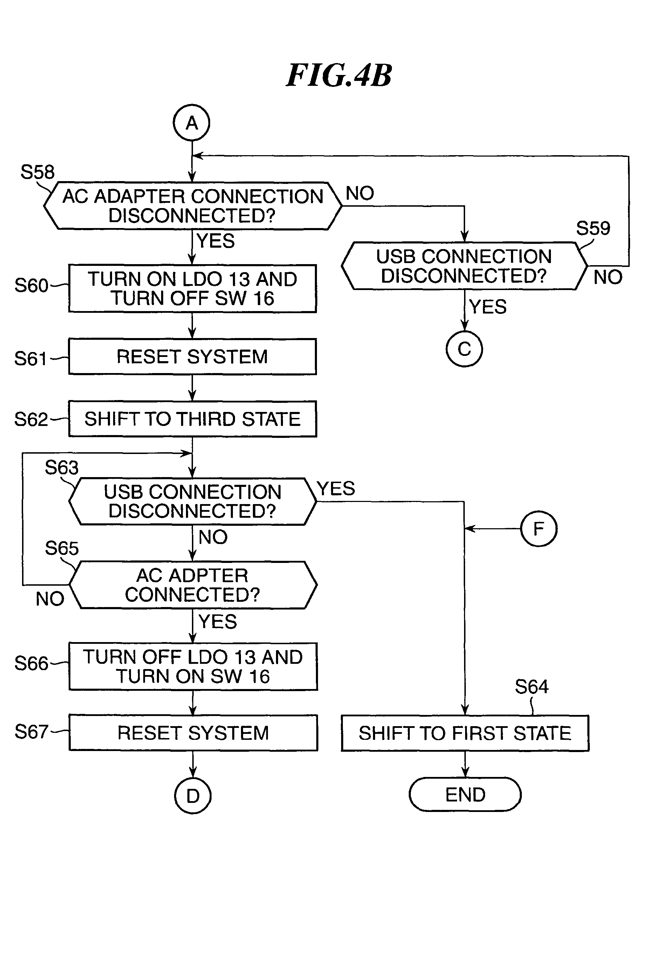

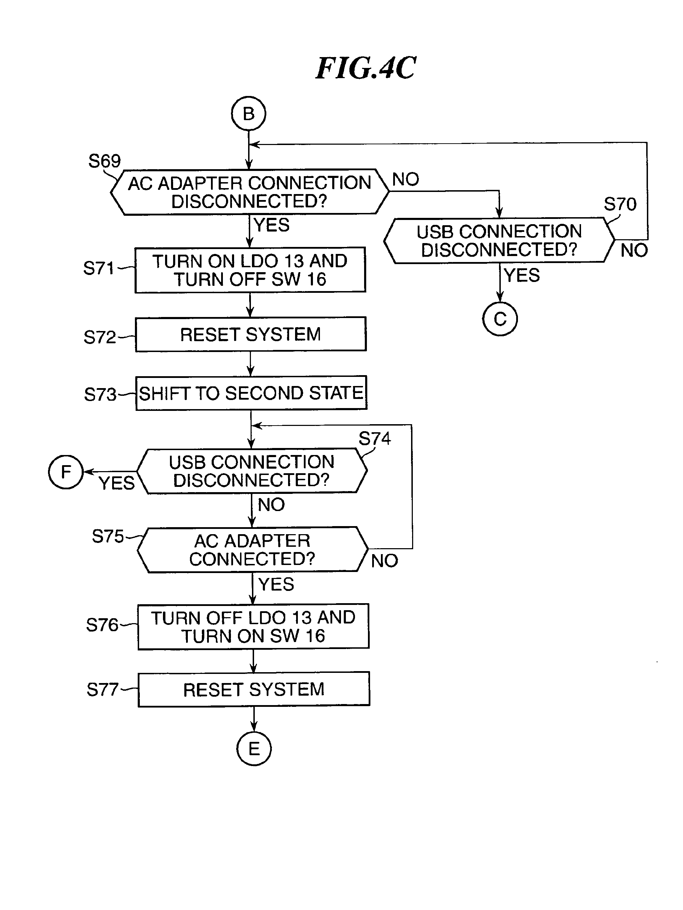

FIGS. 3A, 3B, and 4A to 4C show in flowchart the procedures of an operation state switching process performed by the speaker apparatus 1. FIGS. 3A and 3B show in flowchart the procedures of operation in a case where the speaker apparatus 1 is connected to the host device 30, and FIGS. 4A to 4C show in flowchart the procedures of operation in a case where the AC adapter 40 is connected to the speaker apparatus.

Referring to FIGS. 3A and 3B, when the speaker apparatus 1 is USB connected to the host device 30, the first LDO 13 is turned on so that the CPU 21 is activated (step S11). Subsequently, the CPU 21 performs a negotiation with the host device 30 (step S12). If the negotiation is established, the speaker apparatus 1 is switched to the third operation state where the apparatus is driven with bus power (steps S12 and S13).

Then, whether the AC adapter 40 is connected to the speaker apparatus 1 is determined (step S14). If the AC adapter 40 is not connected, it is determined whether USB connection between the speaker apparatus 1 and the host device 30 is disconnected (step S15). If the USB connection is not disconnected, the flow returns to step S14. On the other hand, if the USB connection is disconnected, the speaker apparatus 1 is switched to the first operation state (step S16), and the operation state switching process is completed (whereby a power off state is entered).

If it is determined in step S14 that the AC adapter 40 is connected to the speaker apparatus 1, the first LDO 13 is turned off and the third SW 16 is turned on (step S17). Then, the system of the speaker apparatus 1 is once reset (step S18), and the speaker apparatus 1 is switched to the sixth operation state (step S19), so that the speaker apparatus 1 is driven with both bus power and self power.

Subsequently, whether USB connection is disconnected is determined (step S20). If the USB connection is not disconnected, it is determined whether the AC adapter connection is disconnected (step S21). If it is determined in step S20 that the USB connection is disconnected, the speaker apparatus 1 is switched to the fourth operation state (step S22), whereupon the operation state switching process is completed (whereby electric power remains ON).

If it is determined in step S21 that AC adapter connection is disconnected, the first LDO 13 is turned on and the third SW 16 is turned off (step S23). Then, the system is once reset (step S24), and the flow proceeds to step S13 in which the speaker apparatus 1 is switched to the third operation state where the apparatus is driven with bus power.

If it is determined in step S12 that the CPU 21 has failed to establish a negotiation with the host device 30, the speaker apparatus 1 is switched to the second operation state (step S31), and whether the AC adapter 40 is connected to the speaker apparatus 1 is determined (step S32). If the AC adapter 40 is not connected, the speaker apparatus 1 is switched to the first operation state (step S33), whereupon the operation state switching process is completed (whereby a power off state is entered).

If the AC adapter 40 is connected, the third SW 16 is turned on (step S34), and the speaker apparatus 1 is switched to the fifth operation state (step S35) in which the apparatus is driven with self power. Subsequently, whether the USB connection is disconnected is determined (step S36). If the USB connection is not disconnected, whether the AC adapter connection is disconnected is determined (step S37). If it is determined in step S36 that the USB connection is disconnected, the speaker apparatus 1 is switched to the fourth operation state (step S22), and the operation state switching process is completed (whereby electric power remains ON).

If it is determined in step S37 that the AC adapter connection is disconnected, the first LDO 13 is turned on and the third SW 16 is turned off (S38). Then, the system is once reset (S39), and the flow proceeds to step S31 in which the speaker apparatus 1 is switched to the second operation state.

Next, with reference to FIGS. 4A to 4C, a description will be given of the procedures of an operation state switching process performed in a case where the AC adapter 40 is connected to the speaker apparatus 1. When the AC adapter 40 is connected to the speaker apparatus 1, the third SW 16 is turned on so that the CPU 21 is activated (step S51). Subsequently, whether the speaker apparatus 1 is USB connected to the host device 30 is determined (step S52). If the speaker apparatus is not USB connected to the host device, the speaker apparatus 1 is switched to the fourth operation state (step S53), and whether the AC adapter connection is disconnected is determined (step S54). If the AC adapter connection is not disconnected, the flow proceeds to step S52 in which whether the speaker apparatus 1 is USB connected to the host device 30 is determined. If it is determined in step S54 that the AC adapter connection is disconnected, the speaker apparatus 1 is switched to the first operation state (step S55), and the operation state switching process is completed.

On the other hand, if it is determined in step S52 that the speaker apparatus 1 is USB connected to the host device 30, the CPU 21 performs a negotiation with the host device 30 (step S56). If the negotiation is established, the speaker apparatus 1 is switched to the sixth operation state where the apparatus is driven with both bus power and self power (step S57).

Then, it is determined whether the AC adapter connection is disconnected (step S58). If the AC adapter connection is not disconnected, whether the USB connection is disconnected is determined (step S59). If it is determined in step S59 that the USB connection is disconnected, the flow proceeds to step S53 in which the speaker apparatus 1 is switched to the fourth operation state.

If it is determined in step S58 that the AC adapter connection is disconnected, the first LDO 13 is turned on and the third SW 16 is turned off (step S60). Then, the system is once reset (step S61), and the speaker apparatus 1 is switched to the third operation state (step S62) in which the apparatus is driven with bus power.

Subsequently, whether the USB connection is disconnected is determined (step S63). If the USB connection is not disconnected, whether the AC adapter 40 is connected to the speaker apparatus 1 is determined (step S65). If the USB connection is disconnected, the flow proceeds to step S64 in which the speaker apparatus 1 is switched to the first operation state, and the operation state switching process is completed (whereby electric power is turned off).

If it is determined in step S65 that the AC adapter 40 is connected, the first LDO 13 is turned off and the third SW 16 is turned on (step S66). Then, the system is once reset (step S67), and the flow proceeds to step S57 in which the speaker apparatus 1 is switched to the sixth operation state where the apparatus is driven with both bus power and self power.

If it is determined in step S56 that a negotiation with the host device 30 cannot be established, the CPU 21 switches the speaker apparatus 1 to the fifth state where the apparatus is driven with self power (step S68). Then, whether the AC adapter connection is disconnected is determined (step S69), and whether the USB connection is disconnected is determined (step S70). If it is determined in step S70 that the USB connection is disconnected, the flow proceeds to step S53 in which the speaker apparatus 1 is switched to the fourth operation state.

If it is determined in step S69 that the AC adapter connection is disconnected, the first LDO 13 is turned on and the third SW 16 is turned off (step S71). Then, the system is once reset (step S72), and the speaker apparatus 1 is switched to the second operation state (step S73). Subsequently, whether the USB connection is disconnected is determined (step S74). If the USB connection is disconnected, the flow proceeds to step S64 in which the speaker apparatus 1 is switched to the first operation state, and the operation state switching process is completed (whereby electric power is turned off).

If the USB connection is not disconnected, whether the AC adapter 40 is connected to the speaker apparatus 1 is confirmed (step S75). If the AC adapter 40 is connected, the first LDO 13 is turned off and the third SW 16 is turned on (step S76). Then, the system is once reset (step S77), and the flow proceeds to step S68 in which the speaker apparatus 1 is switched to the fifth operation state so as to be driven with self power.

As described above, switching is made between the bus-powered driving, the self-powered driving, and the bus and self-powered driving, thereby switching an amount of electric power (especially, electric current) supplied from the first and second current limiting circuits 19, 20 to the capacitor 25, whereby a stable operation can be realized while ensuring an amount of electric power (especially, electric current) supplied to the power amplifier.

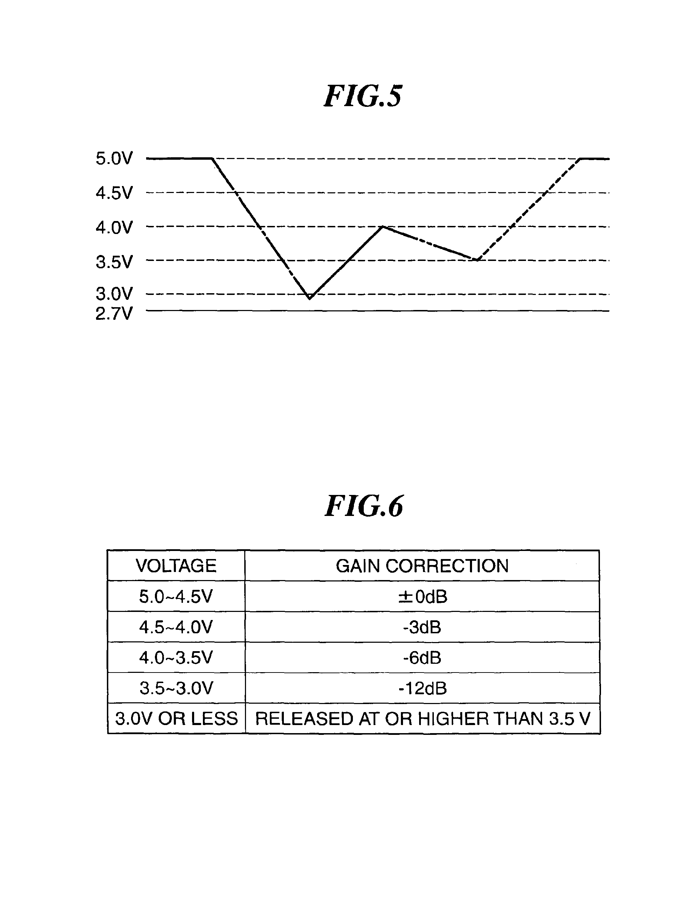

FIG. 5 shows a change in voltage of the capacitor 25 with change in power consumption of the power amplifier 24. As shown in FIG. 5, the capacitor 25 is supplied with a voltage of 5 V from the USB power input circuit 11 or from the AC adapter power input circuit 12, and therefore the capacitor 25 is charged to 5 V at the maximum. If the power amplifier 24 does not consume electric power (or is driven at or below 100 mA or 150 mA), the voltage across the capacitor 25 is maintained at 5 V.

When the power amplifier 24 consumes electric power, an electric current is supplied from the capacitor 25 to the power amplifier 24, and the voltage of the capacitor 25 decreases as shown by a one-dotted chain line in FIG. 5. When sound emission stops and the power amplifier 24 does not consume electric power, the capacitor 25 is again supplied with electric power and charged as shown by a solid line.

The larger the degree of amplification by the power amplifier 24 is (i.e., the larger the emitted sound volume is), the larger the power consumption (and consequently the larger the inclination of voltage reduction of the capacitor 25) will be. On the other hand, the smaller the degree of amplification is, the smaller the inclination of voltage reduction will be. For example, the inclination of voltage reduction is made small as shown by a two-dotted chain line when an emitted sound volume is made smaller than in the case of sound emission accompanied by a voltage reduction shown by one-dotted chain line in FIG. 5. If no sound is emitted, an electric current supplied to the capacitor 25 remains unchanged at 100 mA or 150 mA, and the voltage increasing inclination is as shown by a dotted line, which is not different from that shown by a solid line.

Provided that the power consumption by the power amplifier 24 is the same, the lower the voltage of the capacitor 25 is, the larger the electric current supplied from the capacitor 25 to the power amplifier 24 will be. For this reason, if the voltage of the capacitor 25 becomes less than a predetermined value (e.g., 2. 7 V ), the required electric current cannot be supplied from the capacitor 25 to the power amplifier 24, so that the output from the power amplifier 24 goes down (and no sound is emitted). It should be noted that even if the output of the power amplifier 24 goes down, the entire speaker apparatus 1 does not go down since electric power is supplied to the CPU 21 from either the USB power input circuit 11 or the AC adapter power input circuit 12.

In this embodiment, the following processing is performed to prevent the output of the power amplifier 24 from going down.

### (1) Gain Correction

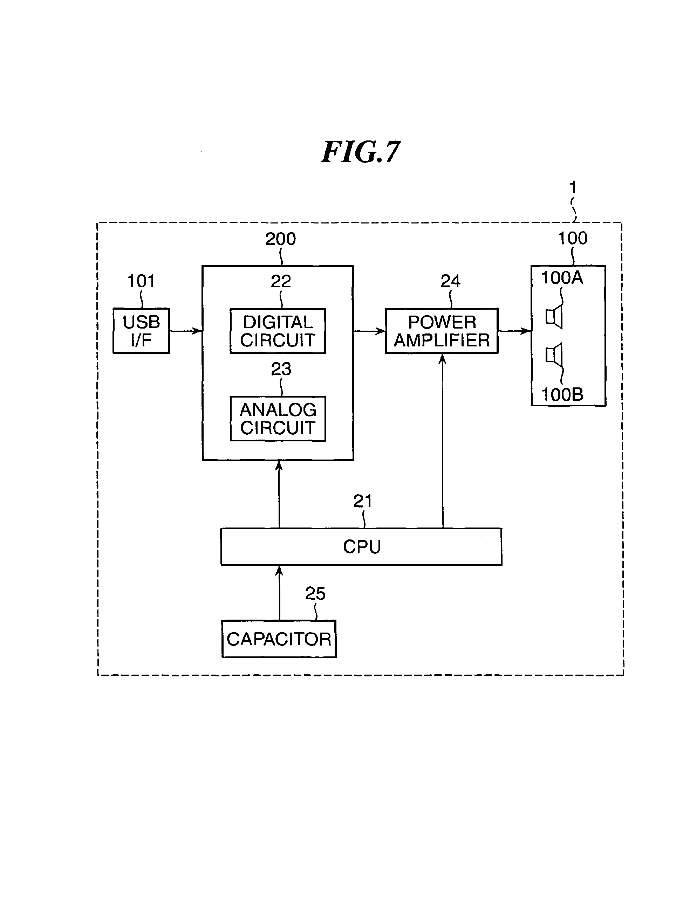

FIG. 6 shows the concept of gain control for the power amplifier performed in accordance with the voltage of the capacitor 25, and FIG. 7 shows in block diagram an audio signal processing system of the speaker apparatus 1. The speaker apparatus 1 includes, as the audio signal processing system, a signal processing circuit 200 and a speaker system 100 having two speaker units 100A, 100B. Audio information input from the USB interface 101 is input, as a digital audio signal, to the signal processing circuit 200. The signal processing circuit 200 comprised of the digital circuit 22 and the analog circuit 23 performs level correction and phase control of the input digital audio signal, and outputs an analog audio signal to the power amplifier 24. The analog audio signal amplified by the power amplifier 24 is emitted as a sound from the speaker system 100. It should be noted that in actuality two-channel audio signals are processed and different sounds are emitted from the speaker units 100A, 100B (for stereo reproduction) in the speaker apparatus 1. However, for simplicity of description, a one-channel audio signal processing system is shown in FIG. 7.

The signal processing circuit 200, the power amplifier 24, and the capacitor 25 are connected to the CPU 21. The CPU 21 controls the way of processing by the signal processing circuit 200 and controls the gain of the power amplifier 24. The voltage of the capacitor 25 is also managed by the CPU 21. As shown in FIG. 6, if the voltage of the capacitor 25 is in a range from 4.5 V to 5 V, the CPU 21 does not correct the gain of the power amplifier 24 (±0 dB). Specifically, since the voltage of the capacitor 25 is sufficiently high, the gain correction is not performed, and an audio signal input from the USB interface 101 is amplified with a prescribed gain by the power amplifier 24 and then emitted as a sound.

If the voltage of the capacitor 25 is in a range from 4 V to 4.5 V, the CPU 21 corrects the gain of the power amplifier 24 by -3 dB. By correcting the gain by -3 dB, sound volume is made small and the power consumption by the power amplifier 24 becomes small. As a result, the inclination of reduction of the voltage of the capacitor 25 becomes small. If the voltage of the capacitor 25 is in a range from 3.5 V to 4 V, the CPU 21 corrects the gain by -6 dB. If the voltage of the capacitor 25 is in a range from 3 V to 3.5 V, the gain is corrected by -12 dB. The lower the voltage value of the capacitor 25 is, the larger the gain correction (and consequently the smaller the sound volume) will be. As a result, the inclination of reduction of the voltage of the capacitor 25 becomes further small, whereby the reduction of the voltage of the capacitor 25 can be suppressed. If the voltage of the capacitor 25 is equal to or less than 3 V, the audio signal is muted so that the power consumption by the power amplifier 24 becomes zero. It should be noted that after the voltage of the capacitor 25 becomes equal to or less than 3 V, muting is continued until the voltage is restored to some extent (e.g., 3. 5 V). When the audio signal is muted, the power consumption by the power amplifier 24 becomes zero, and therefore the voltage value of the capacitor 25 is immediately restored. However, there is a fear that subsequent sound emission causes the voltage to be decreased again to or below 3 V. In that case, muting and muting releasing are alternately repeated. To obviate this, a muting releasing level is set to be equal to or higher than 3. 5 V, taking into account of a margin.

As described above, the gain of the power amplifier 24 is corrected in accordance with a voltage value of the capacitor 25, whereby the output of the power amplifier 24 is prevented from going down.

### (2) Reproduction Mode Switching

Next, a description will be given of audio signal reproduction mode switching. In the speaker apparatus 1 including the speaker system 100 having two-channel speaker units 100A, 100B as shown in FIG. 7, the reproduction mode is switched between a mode for stereo reproduction of audio signal and a mode for monaural reproduction (one channel reproduction) of audio signal. Also, switching is made between a mode where the phase control of audio signal is performed using the two speaker units 100A, 100B to reproduce the audio signal such that a virtual sound source will be generated and a mode where audio signal is reproduced without making the phase control.

Specifically, in a case that a reduction in voltage of the capacitor 25 is small, the CPU 21 makes settings such that phase control is performed by the signal processing circuit 200 on audio signal, and reproduces the audio signal such that a virtual sound source will be generated. If the voltage of the capacitor 25 decreases in some extent, the CPU 21 makes settings such that the phase control is not performed by the signal processing circuit 200, and switching is made to normal stereo reproduction. If the voltage of the capacitor 25 further decreases, the CPU 21 inhibits audio signal supply to either the speaker unit 100A or 100B (or mutes the audio signal for either channel), and performs switching to monaural reproduction. To generate a virtual sound source by the phase control, the required gain is about two times as high as a gain required to obtain the same sound pressure in the normal stereo reproduction, and thus the inclination of reduction in voltage of the capacitor 25 becomes large. On the other hand, in the monaural reproduction, it is enough to give electric power for driving a one-channel speaker, and therefore, the inclination of reduction of voltage of the capacitor 25 becomes small. In view of this, the above-described reproduction mode switching is performed in accordance with a voltage value of the capacitor 25, to prevent the output of the power amplifier 24 from going down.

The audio signal reproduction mode can be switched in accordance with the form of electric power supply from the USB power input circuit 11 and the AC adapter power input circuit 12. For example, when the speaker apparatus 1 is driven with bus power, monaural reproduction of audio signal is performed. When the speaker apparatus is driven with self power, stereo reproduction of audio signal is performed. When the speaker apparatus is driven with both bus power and self power, audio signal is reproduced such as to generate a virtual sound source.

It should be noted that the reproduction mode can be switched while making the gain correction.

In this embodiment, the speaker apparatus has been described as the electronic device. However, this invention is applicable to any electronic device so long as it can be driven with bus power via USB connection and with self power via AC adapter.

In this embodiment, an example has been described where the form of electric power supply is switched between bus-powered driving and self-powered driving. The described construction is not essentially required, but also applicable to an ordinary electronic device that performs ordinary power supply (that does not comprise a power supply switching function). For example, in the case of an electronic device only operable using a built-in battery, the battery voltage lowers with elapse of use time. When the battery voltage lowers, a power amplifier output is saturated at a small signal level or the operation of electronic device stops. By applying the technique disclosed in the embodiment, the electronic device can be used for a longer time.

In this embodiment, the amplifier gain correction or the audio signal reproduction mode is switched in accordance with a voltage value of the capacitor. However, the gain correction or the reproduction mode can be switched in accordance with a voltage value of the power amplifier.

### Industrial Applicability

According to the electronic device of this invention, it is possible to prevent operation stop caused by a reduction of device operation voltage, and to realize a stable operation while ensuring an amount of electric power supply (especially, an amount of electric current supply) to the electronic device.

## Claims

1. An electronic device comprising:
a power input unit configured to be supplied with electric power;
a main drive circuit configured to be driven with electric power supplied from said power input unit; and
a control unit configured to correct a gain of said main drive circuit in accordance with a voltage value of said main drive circuit.

2. The electronic device according to claim 1, including:
an electricity storage circuit connected to a stage preceding said main drive circuit,
wherein said control unit controls the gain of said main drive circuit in accordance with a voltage value of said electricity storage circuit.

3. The electronic device according to claim 3, wherein said main drive circuit is a power amplifier, and
said control unit corrects the gain of the power amplifier in accordance with decrease in voltage value of said electricity storage circuit.

4. An electronic device comprising:
a power input unit configured to be supplied with electric power;
a power amplifier configured to be driven with electric power supplied from said power input unit;
a plurality of speaker units configured to input an audio signal amplified by said power amplifier and emit sounds; and
a control unit configured to change, in accordance with a voltage value of said power amplifier, a way of supply of the audio signal to said power amplifier and said speaker units.

5. The electronic device according to claim 4, including:
an electricity storage circuit connected to a stage preceding said power amplifier,
wherein said control unit changes, in accordance with a voltage value of said electricity storage circuit, the way of supply of the audio signal to the power amplifier and the speaker units.

6. The electronic device according to claim 5, wherein in a case where the voltage value of said electricity storage circuit or said power amplifier is at or near its upper limit, said control unit performs audio signal processing, including phase control, on the audio signal to be supplied to the plurality of speaker units such that a virtual sound source will be generated in a sound emission space.

7. An electronic device comprising:
a plurality of power input units configured to be supplied with electric power of different electric currents;
a plurality of current limiting circuits configured to limit, using different limit values, respective ones of currents input from said plurality of power input units and to output resultant currents;
a main drive circuit connected to a stage subsequent to said plurality of current limiting circuits;
an electricity storage circuit connected between said plurality of current limiting circuits and said main drive circuit; and
a control unit configured to switch a form of connection between said plurality of power input units and
said plurality of current limiting circuits based on a form of current supply via at least one of said plurality of power input units.

8. The electronic device according to claim 7, wherein said plurality of power input units are comprised of a power input unit for bus power configured to be supplied with electric power from a host device and a power input unit for self power configured to be supplied with electric power from an AC adapter,
said control unit connects the power input unit for bus power to one having a small limit value among said plurality of current limiting circuits in a case where electric power is supplied from the power input unit for bus power, and
said control unit connects the power input unit for self power to one having a large limit value among said plurality of current limiting circuits in a case where electric power is supplied from the power input unit for self power.

9. The electronic device according to claim 8, wherein said power input unit for bus power is comprised of a USB interface, and
said control unit connects said power input unit for bus power to the current limiting circuit having the small limit value in a case where negotiation with the host device is established.

10. The electronic device according to claim 7, wherein the electricity storage circuit is an electric double layer capacitor.
